# EUROPÄISCHE PATENTANMELDUNG

(11) **EP 2 929 938 A1**
(43) Veröffentlichungstag der Anmeldung: **14.10.2015**
(21) Anmeldenummer: 15163209.8
(22) Anmeldetag: 10.04.2015
(51) Int. Cl.: B01L 3/00, C23C 16/44

(54) **ANALYSEBEHÄLTNIS SOWIE ANALYSESYSTEM**

(30) Priorität: 11.04.2014 DE 102014105219
(71) Anmelder: Plasma Electronic GmbH, 79395 Neuenburg (DE)
(72) Erfinder: Stöhr, Uwe, 79395 Neuenburg (DE)
(74) Vertreter: Wagner, Kilian

(57) **Zusammenfassung**

Die Erfindung betrifft ein Analysebehältnis (1), aus einem Behältnismaterial (2), mit einer Kavität (3) zur zumindest zeitweisen Aufnahme einer, mit einem chemischen, physikalischen und/oder biologischen Verfahren zu analysierenden, bevorzugt fluiden, Analysesubstanz. Erfindungsgemäß ist vorgesehen, dass eine Oberfläche der Kavität (3) zur unmittelbaren Kontaktierung der Analysesubstanz von einer ALD-Barrierebeschichtung (4) zur Vermeidung oder Reduzierung einer Diffusion von Atomen und/oder Ionen und/oder Molekülen aus dem Behältnismaterial (2) in die Analysesubstanz gebildet ist.

## Beschreibung

Die Erfindung betrifft ein Analysebehältnis gemäß dem Oberbegriff des Anspruchs 1, aus einem Behältnismaterial, mit einer Kavität zur zumindest zeitweisen Aufnahme einer, mit einem chemischen, physikalischen und/oder biologischen Verfahren zur analysierenden, bevorzugt fluiden, Analysesubstanz. Ferner betrifft die Erfindung ein Analysesystem gemäß Anspruch 11 sowie die Verwendung eines Analysebehältnisses gemäß Anspruch 12. Ferner betrifft die Erfindung ein Verfahren zum Herstellen bzw. Beschichten eines solchen Analysebehältnisses gemäß Anspruch 13.

Zur chemischen, biologischen und/oder physikalischen Analyse von Substanzen, beispielsweise von Blut, anderen Körperflüssigkeiten oder sonstigen, nicht medizinischen Substanzen werden zur Aufnahme der Analysesubstanz Analysebehältnisse eingesetzt, in denen die Analysesubstanz zeitweise entweder zur unmittelbaren Messung, zur Probenaufbereitung oder zur Zwischenlagerung verweilt. Die Analysebehältnisse, beispielsweise Spritzen, Pipettenspitzen, Reaktionsgefäße oder Wellplatten bestehen in der Regel aus Kosten- und Gewichtsgründen aus Kunststoff, was gleichzeitig den Vorteil einer geringen Verletzungsgefahr mit sich bringt. Alternativ ist es bekannt, Analysebehältnisse aus meist kostengünstigen Gläsern auszubilden.

Aufgrund des technischen Fortschrittes in der Analytik werden zunehmend bei der Analyse der Analysesubstanz auch geringste Stoffmengen nachgewiesen, die nicht ursprünglich in der Analysesubstanz vorhanden waren, sondern die aus dem Behältnismaterial des Analysebehältnisses während der Verweildauer der Analysesubstanz in diese hineindiffundiert sind. Dies führt zu entsprechenden Peaks in resultierenden Messdiagrammen. Bei den nachgewiesenen Substanzen handelt es sich vorwiegend um kurzkettige Kohlenwasserstoffe (meist C11 bis C22) sowie um Additive von Kunststoff, die nicht chemisch fest (kovalent) gebunden sind. In erster Linie sind dies Trennmittel und Antistatika, die bei den Kunststoffverarbeitungsprozessen, wie Spritzgussverfahren oder Tiefziehverfahren eingesetzt werden. Auch kann es sich bei den Additiven (Zusatzstoffen) um Reste von Katalysatoren handeln, die zur Kunststoffpolymerisation eingesetzt wurden. Die vorstehende Problematik ist jedoch nicht nur auf Kunststoff-Analysebehältnisse beschränkt, sondern tritt auch bei Glasbehältnisses auf, bei denen Atome und Ionen aus dem Glasmaterial herausgelöst werden können und in die Analysesubstanz übergehen. Dieser Effekt ist als sogenannte Glaskorrosion bekannt.

Bei Gläsern ist es zur Verringerung dieses Effektes bekannt, dieser in Vakuumstandardbeschichtungsprozessen mit einer SiOₓ-Schicht zu versehen, insbesondere um eine alkalifreie Kontaktfläche zur Analysesubstanz zu erhalten. Die Barrierewirkung ist jedoch verbesserungsbedürftig.

Die US 5,763,033 A beschreibt mit einer Barriereschicht beschichtete Blutsammelgefäße. Die zum Einsatz kommende Beschichtung wird mittels eines PECVD-Verfahrens hergestellt, wobei die so erzeugte Barriereschicht Schwächen aufweist - insbesondere kann nicht sichergestellt werden, dass Atome und/oder Moleküle aus dem Blutsammelgefäßmaterial durch die Barriereschicht hindurch in das in einem Blutsammelgefäß aufgenommene Blut hineindiffundieren. Eine Beschichtung von Analysegefäßen mit einem großen Aspektverhältnis (Tiefe/Durchmesser) ist nicht sinnvoll möglich.

Die US 2010/0298738 A1 beschreibt eine Vorrichtung zum Beschichten von Behältnissen mit einer Barriereschicht. Die Barriereschicht wird mittels eines gepulsten PECVD-Verfahrens aufgebracht. Mittels eines PECVD-Verfahrens, auch wenn dieses gepulst ausgeführt wird kann eine Beschichtungsreaktion nicht exakt terminiert werden. Daher weist die resultierende Barriereschicht zwangsläufig Dickenschwankungen auf und ist sinnvoll nicht auf Analysegefäßen mit einem großen Aspektverhältnis aufbringbar.

Ausgehend von dem vorgenannten Stand der Technik liegt der Erfindung die Aufgabe zugrunde, ein verbessertes Analysebehältnis sowie ein Verfahren zu dessen Herstellung anzugeben, bei dem die Diffusionsneigung von Atomen und/oder Molekülen aus dem Behältnismaterial in die Analysesubstanz deutlich reduziert ist oder bevorzugt vollständig vermieden wird. Ferner besteht die Aufgabe darin, ein Analysesystem mit einem entsprechend optimierten Analysebehältnis anzugeben.

Diese Aufgabe wird hinsichtlich des Analysebehältnisses mit den Merkmalen des Anspruchs 1 sowie durch dessen Verwendung gemäß Anspruch 12 gelöst. Hinsichtlich des Analysesystems wird die Aufgabe mit den Merkmalen des Anspruchs 11 gelöst. Hinsichtlich des Verfahrens wird die Aufgabe mit den Merkmalen des Anspruchs 13 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen vorrichtungsgemäß offenbarte Merkmale als verfahrensgemäß offenbart gelten und beanspruchbar sein. Ebenso sollen verfahrensgemäß offenbarte Merkmale auch als vorrichtungsgemäß offenbart gelten und beanspruchbar sein.

Der Erfindung liegt der Gedanke zugrunde, bei einem Analysebehältnis mit einer Kavität zur Aufnahme einer Analysesubstanz, die Kontaktfläche zur unmittelbaren Kontaktierung der Analysesubstanz durch eine ALD-Barrierebeschichtung auszubilden, mit welcher die Diffusion von Atomen und/oder Ionen und/oder Molekülen aus dem Behältnismaterial, insbesondere Kunststoff oder Glas, in die Analysesubstanz reduziert oder vorzugsweise vollständig vermieden wird. Die mit der ALD-Barrierebeschichtung versehene Fläche ist zumindest im Bereich der Kavität dreidimensional ausgeformt, um somit die notwendigerweise dreidimensionale Kavität an ihrem Innenumfang zur unmittelbaren Kontaktierung der Analysesubstanz begrenzen zu können. Eine ALD-Barrierebeschichtung hat gegenüber dem Stand der Technik erhebliche Vorteile. Insbesondere ist die Barrierewirkung im Vergleich zu sonstigen Barriereschichten optimiert, da sie sehr wenige bis keine Fehlstellen aufweist. Dies ist insbesondere darauf zurückzuführen, dass eine ALD-Barrierebeschichtung gegenüber anderen bekannten Dünnschichtabscheidungsverfahren eine nahezu perfekte Stöchiometrie aufweist. Dies ist wiederum darauf zurückzuführen, dass bei der Atomlagenabscheidung (ALD) die Ausgangsstoffe (mindestens zwei), sogenannte Präkusoren zyklisch nacheinander in die Reaktionskammer eingelassen werden. Zwischen den Gaseinlässen der Ausgangsstoffe wird die Reaktionskammer gespült, in der Regel mit einem Inertgas, wie beispielsweise Argon. Auf diese Weise werden die Teilreaktionen klar voneinander getrennt und auf die Oberfläche begrenzt. Wesentliches Merkmal des ALD-Verfahrens bzw. einer ALD-Barrierebeschichtung ist der selbstbegrenzende Charakter der Teilreaktion bei deren Herstellung, d.h. der Ausgangsstoff einer Teilreaktion reagiert nicht mit sich selbst oder Liganden von sich selbst, was das Schichtwachstum einer Teilreaktion bei beliebig langer Zeit und Gasmenge auf maximal eine Monolage begrenzt.

Der Einsatz einer ALD-Barrierebeschichtung auf Analysebehältnissen zur Bildung einer Barriere-Kontaktoberfläche zu einer analysierenden Anlaysesubstanz ist neu und aufgrund der hervorragenden, erwähnten Barriereeigenschaften von besonderem Vorteil. Besonders hervorzuheben ist, dass sich der Einsatz einer ALD-Barrierebeschichtung auch auf Kunststoffbehältnisse hervorragend eignet bzw. realisieren lässt, insbesondere wenn hierzu ein plasmaunterstütztes ALD-Verfahren eingesetzt wird, bei dem die Prozesstemperaturen unter 100°C gesenkt werden können. Hierdurch wird ein sonst denkbares Aufschmelzen des Behältnismaterials sicher verhindert.

Wie eine Analyse auf fachfremdem Stand der Technik ergeben hat, wurde das Verfahren der Atomlagenabscheidung (englisch: Atomic Layer Deposition - ALD) bereits 1977 in der US 4,058,430 beschrieben. Das ALD-Verfahren wurde in den vergangen Jahrzehnten insbesondere in der Halbleiterindustire eingesetzt. Das plasmaunterstützte ALD-Verfahren wurde im Jahr 1985 entwickelt und wird im Rahmen der vorliegenden Anmeldung als plasmaunterstütztes ALD-Verfahren bzw. PA-ALD-Verfahren bezeichnet. Das Verfahren ist beispielsweise in der US 4,935,661 beschrieben. Optimiert wurde das Verfahren von Herrn Oliver FeddersenClausen. Der optimierte Prozess zur Beschichtung von dreidimensionalen Gegenständen wurde in der DE 10 2011 104 132 B3 beschrieben. Bevorzugt wird die erfindungsgemäße ALD-Barrierebeschichtung, wie in dem letztgenannten Dokument beschrieben aufgebracht, besonders bevorzugt auf die Innenseite der Kavität. Insoweit wird der Inhalt der DE 20 2011 104 132 B3 hiermit als zu vorliegenden Offenbarung gehörig offenbart. Bei Analysebehältnisse, wie Pipettenspitzen, die sich durch eine längliche Bauform auszeichnen, insbesondere mit axial einander gegenüberliegender Einlass- und Auslassöffnung ist es bevorzugt, wenn diese in der Beschichtungskammer so angeordnet werden, dass diese beim Beschichtungsvorgang, insbesondere durch eine entsprechende Absaugungseinrichtung von den Präkusorgasen und/oder Spülgasen in Richtung der Längserstreckung der Kavität durchströmt werden, um somit eine homogene Beschichtung zu erreichen.

Um eine gute Barrierewirkung zu erzielen, umfasst die ALD-Barrierebeschichtung alternativ eine einzige oder mehrere Barrierebeschichtungslagen. Jede Barrierebeschichtungslage wiederum besteht bevorzugt aus einer Mehrzahl von Atom- und/oder Moleküllagen (Monolagen), ganz besonders bevorzugt jeweils mindestens 50 Atom- und/oder Moleküllagen, noch weiter bevorzugt jeweils mit einer homogenen Stöchiometrie.

Wie erläutert, ist also eine Ausführungsform realisierbar, bei der die ALD-Barrierebeschichtung aus einer einzigen Barrierebeschichtungslage, umfassend mehrere Monolagen (Atom- und/oder Moleküllagen) besteht. Die Atom- und/oder Moleküllagen weisen bevorzugt eine identische homogene Stöchiometrie auf. Bei der alternativen Ausführung mit mehreren Barrierebeschichtungslagen, jeweils umfassend eine Vielzahl von Monolagen gibt es unterschiedliche Möglichkeiten. So ist es möglich, dass die Barrierebeschichtungslagen oder zumindest zwei aufeinander folgende Barrierebeschichtungslagen gleich aufgebaut sind, d.h. jeweils aus Monolagen mit identischer Stöchiometrie bestehen. Alternativ ist es möglich, Wechsel-Barrierebeschichtungslagen zu realisieren, wobei beispielsweise eine erste Barrierebeschichtungslage eine Vielzahl von ersten Atom- und/oder Moleküllagen aufweist und eine darauf folgende zweite Barrierebeschichtungslage eine Vielzahl von von den ersten Atom- und/oder Moleküllagen unterschiedlichen zweiten Atom- und/oder Moleküllagen. So ist es beispielsweise möglich, dass eine erste Barrierebeschichtungslage aus einer Vielzahl von Al₂O₃-Monolagen besteht und die daran angrenzende weitere Barrierebeschichtungslage aus TiN-Monolagen. Ganz besonders bevorzugt ist es, wenn eine alternierende Anordnung von Barrierebeschichtungslagen realisiert ist, beispielsweise eine Barrierebeschichtungslagenfolge: Al₂O₃, TiN, Al₂O₃.

Bevorzugt ist die Gesamtschichtdicke der ALD-Barrierebeschichtung bestehend aus einer einzigen oder mehreren, jeweils eine Vielzahl von Monolagen umfassenden Barrierebeschichtungslagen aus einem Wertebereich zwischen 6 nm und 100 nm, bevorzugt zwischen 9 nm und 85 nm, ganz besonders bevorzugt zwischen 12 nm und 70 nm gewählt.

Wie erwähnt, wird durch das erfindungsgemäße Vorsehen einer ALD-Barrierebeschichtung in einem Analysebehältnis die Diffusionsneigung von Atomen, Molekülen und/oder Ionen minimiert. Darüber hinaus wird als zusätzlicher Effekt erreicht, dass eine Migration von Bestandteilen, insbesondere Molekülen der Analysesubstanz in das Behältnismaterial verhindert wird, mit dem Effekt, dass im Stand der Technik möglicherweise auftretende Reaktionen bzw. Löseeffekte verringert bzw. vermieden werden, die zu einer weiteren Anreicherung der Analysesubstanz mit Fremdbestandteilen führen könnten.

Zusätzlich zu dem Vorsehen der Beschichtung als Oberfläche der Kavität ist es möglich, das Analysebehältnis auch an seinem Außenumfang mit der ALD-Barrierebeschichtung zu versehen, wobei es im Hinblick auf einen vereinfachten Beschichtungsvorgang von Vorteil ist, wenn das Analysebehältnis vollumfänglich, d.h. sowohl am Außenumfang als auch am Innenumfang mit der ALD-Barrierebeschichtung versehen ist.

Die erfindungsgemäß zum Herstellen einer Barriereschicht in Analysebehältnissen zur Anwendung kommende ALD-Technologie unterscheidet sich grundlegend von der bisher im Stand der Technik für diesen Zweck eingesetzten chemischen Gasphasenabscheidungstechnologie (CVD) und ist dieser überlegen. Bei der chemischen Gasphasenabscheidung werden Schichten aus der Gasphase abgeschieden. Um die dazu notwendige chemische Reaktion in Gang zu bringen, benötigt man entweder hohe Temperaturen oder ein Plasma (PECVD). Der Nachteil dieses bekannten Verfahrens besteht darin, dass die Bewegung der Moleküle im Gas stochastisch erfolgt, und dass die Reaktion der Gasmoleküle mit der Oberfläche sofort stattfindet, sobald die Moleküle das erste Mal die Oberfläche berühren. Diese Reaktion ist nicht reversibel.

Hier setzt die ALD-Technologie an. Bei diesem erfindungsgemäß bei Analysebehältnissen zum Einsatz kommenden Verfahren werden zwar auch Gasmoleküle verwendet; der Unterschied zu einem CVD-Prozess, insbesondere einem PECVD-Prozess besteht darin, dass die Moleküle nur mit der Oberfläche reagieren können, wenn die Oberfläche noch keine Beschichtung aufweist. Dadurch kann bei einem Beschichtungsdurchgang immer nur genau eine Moleküllage auf die Oberfläche gelangen. Treffen bei einem ALD-Verfahren Gasmoleküle auf Oberflächenbereiche, die bereits mit absorbierten Molekülen abgesättigt sind findet keine Reaktion mit der Oberfläche statt. Die Glasmoleküle diffundieren daher weiter, bis sie auf einen noch nicht abgesätigten Oberflächenbereich treffen. Eine Reaktion der Moleküle untereinander ist stark unterdrückt. Bei einem im Rahmen der Erfindung eingesetzten ALD-Verfahren kann also im Gegensatz zu einem CVD-Verfahren, insbesondere einem PECVD-Verfahren nach Sättigung der Oberfläche beliebig viel und lange weiter Gas zugeführt werden, ohne dass noch eine Reaktion stattfindet. Um die Schicht bzw. Beschichtung weiter dickenmäßig wachsen zu lassen, muss das Gas in der Beschichtungskammer getauscht werden, um damit in einem weiteren Prozessschritt die eben aufgebrachte Moleküllage chemisch zu optimieren. Anschließend wird wieder das Prozessgas getauscht und eine weitere Moleküllage (Monolage) aufgebracht. Für die hier im Zusammenhang mit Barrierebeschichtungen auf Analysebehältnissen beanspruchte "echte" ALD-Technologie, bei der pro Prozessschritt exakt eine einzige Atom- oder Moleküllage aufgebaut wird werden daher zeitlich versetzt verschiedene Prozessgase in die Beschichtungskammer eingelassen, wobei die Prozessgase nicht gleichzeitig in der Beschichtungskammer sind bzw. sein dürfen. Würden unterschiedliche Prozessgase gleichzeitig in der Beschichtungskammer vorhanden sein (was bei der erfindungsgemäß zum Einsatz kommenden ALD-Barriereschicht nicht der Fall ist), würde es sich nicht mehr um eine ALD-Barrierebeschichtung handeln, sondern um eine konventionelle CVD-Barrierebeschichtung.

Die ALD-Technologie macht überhaupt erst eine homogene Beschichtung von Analysebehältnisse mit einem hohem Aspektverhältnis und bevorzugt nur einer Öffnung möglich. Bevorzugt haben die zum Einsatz kommende bzw. mit einer ALD-Barrierebeschichtung beschichteten Anlaysebehältnisse ein Aspektverhältnis, d.h. ein Verhältnis aus Analysebehältnistiefe und Öffnungsdurchmesser von größer oder gleich 1 : 1, vorzugsweise von größer oder gleich 2 : 1, weiter bevorzugt von größer oder gleich 3 : 1, noch weiter bevorzugt von größer oder gleich 5 : 1, ganz besonders bevorzugt von größer oder gleich 7,5 : 1, noch weiter bevorzugt großer als oder gleich 10 : 1 , besonders bevorzugt größer als oder gleich 15 : 1, ganz besonders bevorzugt größer als oder gleich 20 : 1. Anders ausgedrückt entspricht das Aspektverhältnis zwischen der Tiefe einer, vorzugsweise eine einzige Öffnung aufweisenden, bevorzugt einen kreisrunden Querschnitt aufweisenden, Kavität und dem Kavitätendurchmesser, insbesondere im Bereich der vorgenannten Öffnung einen vorgenannten Wert. Würde man derartige Analysebehältnisse mit einer CVD-Technlogie beschichten, wäre es stochastisch betrachtet äußerst unwahrscheinlich, dass Gasmoleküle den Analysebehältnisboden erreichen ohne vorher die Seitenwand des Gefäßes berührt zu haben. Hierdurch würde die CVD-Barrierebeschichtung im Öffnungsbereich vergleichsweise dick, während am Gefäßboden kaum eine Schicht abgeschieden werden kann. Die CVD-Barrierebeschichtung wäre dann nicht dicht und könnte ihre Funktion nicht hinreichend erfüllen.

Insbesondere für den bevorzugten Fall der Ausbildung des Analysebehältnisses aus Kunststoff ist es bevorzugt, wenn die ALD-Barrierebeschichtung mittels eines plasmaunterstützten ALD-Verfahrens, insbesondere bei einer Prozesstemperatur von weniger als 100°C, ganz besonders bevorzugt bei Atmosphärendruck oder im Vakuum aufgebracht ist bzw. wird, da hierdurch verhindert wird, dass das Kunststoffmaterial, bei dem es sich bevorzugt um ein Standard-Kunststoffmaterial handelt, nicht schmilzt oder in seiner Struktur geschädigt wird. Die üblicherweise zur Herstellung von Analysebehältnissen zum Einsatz kommenden Kunststoffe können nicht über 100°C bis 120°C erwärmt werden, ohne zu schmelzen oder die Struktur nachhaltig zu schädigen.

Ganz besonders bevorzugt ist eine Ausführungsform, wonach die Dickenerstreckung der ALD-Barrierebeschichtung über ihre Flächenerstreckung konstant ist. Dies kann, wie zuvor erläutert, nur durch den Einsatz einer ALD-Technologie erreicht werden - bei CVD-Prozessen gibt es, insbesondere bei den zuvor erwähnten, bevorzugten Aspektverhältnissen zwingend Dickenschwankungen.

Im Hinblick auf die konkrete Ausbildung des Behältermaterials gibt es unterschiedliche Möglichkeiten. Wie bereits angedeutet, kann es sich bei dem Behältnismaterial, welches mittelbar oder unmittelbar mit einer ALD-Barrierebeschichtung versehen ist, um einen Kunststoff oder um einen amorphen Feststoff, insbesondere um Glas handeln. Im Falle der Wahl von Glas als Behältnismaterial kann es sich bei dem Behältnismaterial bevorzugt um Kalk-Natron-Glas, Boro-Silikat-Glas, Blei-Glas oder um ein metallisches Glas handeln.

Im Hinblick auf den Einsatz von Kunststoffen als Behältnismaterial gibt es die unterschiedlichsten Möglichkeiten. In Weiterbildung der Erfindung ist vorgesehen, dass ein Kunststoff der Familie der Polyolefine darunter bevorzugt Polyethylen (PE, LLDPE, LDPE, HDPE, PE-HMW, PE-UHWM, PE-X), Polypropylen (PP) oder Copolymere aus Polypropylen oder Polyethylen eingesetzt wird. Auch ist es möglich, als Kunststoff einen Kunststoff der Familie der Polyester einzusetzen, darunter bevorzugt Polyethylenterephthalat (PET), Polyethylennaphthalat (PEN) und Polybutylenterephthalat (PBT). Ebenfalls ist es bevorzugt einen Kunststoff der Familie der Polyester, darunter bevorzugt Polycarbonate (PC) und der Familie der Polyesterharze einzusetzen. Weiter bevorzugt ist ein Kunststoff der Familie der Polyamide (PA), darunter bevorzugt PA 6, PA 6.6 und PA 6.10 einzusetzen. Besonders bevorzugt ist ein Kunststoff der Familie der Polyurethane (PU). Weiter bevorzugt ist vorgesehen, ein Kunststoff der Familie der Polyacrylate, darunter bevorzugt Polymethylmethacrylat (PMMA). Weiterbildungsgemäß ist ein Kunststoff der Familie der Cyclo-Olefin-Copolymere (COC) vorgesehen, besonders bevorzugt ein Kunststoff der Familie der biologisch abbaubaren und kompostierbaren Kunststoffe gemäß EN 13432, oderbevorzugt ein Kunststoff der Familie der Cyclo-Olefin-Copolymere (COC). Weiterbildungsgemäß ist vorgesehen, dass ein Kunststoff der Familie der Flüssigkristallpolymere (englisch Liquid crystal polymers, LCP) eingesetzt wird. Besonders bevorzugt ist ein Kunststoff der Familie der Polyramide, weiterbildungsgemäß bevorzugt ein Kunststoff der Familie der Polyimide, darunter besonders bevorzugt Polyetherimid (PEI), Poly (4,4' -oxydiphenylen-pyromellitimid)und Polybenzimidazol (PBI). In Weiterbildung der Erfindung ist vorgesehen, einen Kunststoff der Familie der Polyether, darunter besonders bevorzugt aus den Kunststoffen der Familie der Polyetherketone, darunter wiederum bevorzugt auf Polyetheretherketon (PEEK) einzusetzen. Weiter bevorzugt ist vorgesehen einen Kunststoff der Familie der Terpolymere, weiterbildungsgemäß darunter ganz besonders bevorzugt auf Acrylnitril-Butadien-Styrol (ABS).

Ganz besonders bevorzugt ist vorgesehen ein Kunststoff der Familie der schwefelhaltigen Polymere, darunter besonders bevorzugt Polyphenylensulfid (PPS) und Polythiophen einzusetzen. In Weiterbildung der Erfindung ist es auch vorgesehen, bevorzugt den Kunststoff der Familie der Vinylpolymere, darunter besonders bevorzugt auf Polystyrol (PS), Polyvinylalkohol (PVA), Polyvinylacetat (PVAc) und Polyacrylnitril (PAN) einzusetzen. Besonders bevorzugt ist es den Kunststoff der Familie der Polysaccharide einzusetzen, weiterbildungsgemäß und besonders bevorzugt ein Kunststoff der Familie der Phenoplaste, darunter besonders bevorzugt Bakelit einzusetzen. In Weiterbildung der Erfindung ist vorgesehen, dass ein Kunststoff der Familie der Aminoplaste, oder einen Kunststoff der Familie der chlorhaltigen Polymere, darunter besonders bevorzugt auf Polyvinylchlorid (PVC) und Polyvinylidenchlorid (PVdC) einzusetzen. Auch ist es möglich, als Kunststoff einen Kunststoff der Familie der Fluorkunststoffe einzusetzen, darunter besonders bevorzugt auf Polyvinylidenfluorid (PVDF) und Polytetrafluorethylen (PTFE). Ferner ist es auch denkbar, ein Kunststoff der Familie der Ethylen-Vinylalkohol-Copolymer (EVOH) einzusetzen. Ferner kann es auch besonders bevorzugt sein Polyoxymethylen (POM) und Copolymeren mit Polyoxymethylen einzusetzen. Ganz besonders bevorzugt ist es auch ein Kunststoff der Familie der Elastomer-Kunststoffen einzusetzen. Weiterbildungsgemäß und besonders bevorzugt ist es denkbar, dass auf Elastomeren der Familie der Silikone, darunter besonders bevorzugt auf Polydimethylsiloxan (PDMS) eingesetzt werden. Auch ist es denkbar, dass auf Elastomeren der Familie der Fluorkautschuke (FKM) eingesetzt wird, ganz besonders bevorzugt auf Elastomeren der Familie der Nitrilkautschuke (NBR). In Weiterbildung der Erfindung ist es bevorzugt auf Elastomeren der Familie der Ethylen-Propylen-Dien-Kautschuke (EPDM) einzusetzen, ganz besonders bevorzugt auf Elastomeren der Familie der Butadien-Kautschuke (BR). Auch ist es möglich auf Elastomeren der Familie der Isopren-Kautschuke (IR) einzusetzen. Weiterbildungsgemäß und ganz besonders bevorzugt auf Elastomeren der Familie der Polyester-Urethan-Kautschuke (AU). In Weiterbildung der Erfindung ist auch vorgesehen bevorzugt Elastomere der Familie der StyrolButadien-Kautschuke (SBR) einzusetzen und besonders bevorzugt auf Elastomeren der Familie der Chloropren-Kautschuke, besonders bevorzugt auf Copolymeren mit Ethylenvinylacetat (EVA), weiterhin bevorzugt auf Naturkautschuk (Gummi) sowie ganz besondere bevorzugt auf Polyisobutylen (PIB). Weiterbildungsgemäß ist es auch möglich besonders bevorzugt auf Hydrierten Acrylnitrilbutadien-Kautschuken (HNBR).

Grundsätzlich ist es möglich, die ALD-Barrierebeschichtung unmittelbar auf dem Behältnismaterial aufzubringen, wobei in diesem Fall die Oberfläche des Behältnismaterials so zu modifizieren ist, dass sich darauf chemisch-reaktive Gruppen befinden, die kovalent mit den Atomen der ALD-Barrierebeschichtung reagieren bzw. bei dem fertigen Analysebehältnis reagiert haben bzw. verbunden sind. Dies kann beispielsweise durch Plasmaaktivierung realisiert werden, entweder bei Niederdruck, vorzugsweise zwischen 0,1 Pa bis 10 Pa oder bei Atmosphärendruck (Coronabehandlung). Durch die Plasmabehandlung ist es beispielsweise möglich, bei Einsatz eines Sauerstoffplasmas Sauerstoffradikale oder Hydroxygruppen an Atome der Oberfläche anzuhängen als Basis für die ALD-Barrierebeschichtung. Alternativ zu einer Plasmabehandlung ist auch eine Beflammung, insbesondere unter Atmosphärendruck zur Oberflächenaktivierung möglich. Alternativ ist es möglich und bevorzugt, auf das Behältnismaterial zunächst ein Plasmapolymer abzuscheiden, mit dem dann die Bestandteile, insbesondere Atome und/oder Moleküle der ALD-Barrierebeschichtung kovalent verbunden sind. Bevorzugt ist es, die Plasmapolymerbeschichtung mit einem Verfahren der plasmaunterstützten Gasphasenabscheidung unter Vakuum aufzubringen (alternativ unter Atmosphärendruck), insbesondere mittels eines PECVD oder PACVD-Verfahrens.

Im Hinblick auf die konkrete Ausgestaltung der ALD-Barrierebeschichtung bzw. die Wahl der Ausgangsstoffe (Präkusoren) gibt es unterschiedliche Möglichkeiten. So können die Präkusoren so gewählt werden, dass mit Atom- und/oder Moleküllagen mindestens einer der folgenden Schichtfamilien realisiert werden: Metall- und Halbmetalloxide, Metall- und Halbmetallnitride, Metall- und Halbmetallcarbide, Metall- und Halbmetallsulfide oder Metall- und Halbmetallboride.

Wie bereits eingangs erwähnt, ist es bevorzugt eine einzige Barrierebeschichtungslage oder mehrere Barrierebeschichtungslagen, jeweils bestehend aus mehreren Atom- und/oder Moleküllagen vorzusehen, besonders bevorzugt mindestens 50 solcher Monolagen, wobei diese bevorzugt jeweils eine definierte Stöchiometrie aufweisen. Grundsätzlich ist es möglich, mehrere gleich zusammengesetzte Barrierebeschichtungslagen vorzusehen oder mindestens zwei unterschiedlich zusammengesetzte Barrierebeschichtungslagen, wobei sich die Atom- und/oder Moleküllagen der unterschiedlichen Barrierebeschichtungslagen unterscheiden.Bevorzugt sind Barrierebeschichtungswechsellagen (Wechsellagen) zur gezielten Beeinflussung der Barrierewirkung realisiert. Bevorzugt ist es beispielsweise denkbar, zunächst mehrere Monolagen Al₂O₃ aufzutragen, bevorzugt mit einer Gesamtdicke von 20 nm als erste Barrierebeschichtungslage und danach mehrere Monolagen TiN, bevorzugt mit einer Gesamtdicke von 20 nm als zweite Barrierebeschichtungslage und danach wieder mehrere Monolagen Al₂O₃, vorzugsweise mit einer Gesamtdicke von wiederum 20 nm als dritte Barrierebeschichtungslage. Ganz besonders bevorzugt ist es, wenn die Stöchiometrie sämtlicher Monolagen jeder Barrierebeschichtungslagen gleich zusammengesetzt ist.

Im Hinblick auf die konkrete Zusammensetzung zumindest einer der vorgenannten Barrierebeschichtungslagen oder einer einzigen Barrierebeschichtungslage ist es möglich, dass diese aus mehreren Monolagen, z.B. Aluminiumoxid, Siliziumdioxid oder Titan(IV)-oxid besteht bzw. bestehen und/oder aus einem Oxid, einem Nitrid, einem Sulfid, einem Borid oder einem Carbid eines Metalls oder eines Halbmetalls.

Wie ebenfalls bereits eingangs angedeutet, ist es besonders bevorzugt, wenn die ALD-Barrierebeschichtung im sogenannten plasmaunterstützten ALD-Verfahren aufgebracht ist, ganz besonders bevorzugt mit einem in der DE 10 2001 104 132 B3 beschriebenen Verfahren, wobei es noch weiter bevorzugt ist, wenn die Prozesstemperatur bei der Aufbringung weniger als 100°C beträgt, um somit ein Schmelzen von Kunststoff, insbesondere von Standard-Kunststoffen zu vermeiden, die als Behältnismaterial eingesetzt werden können, bevorzugt wird die ALD-Barrierebeschichtung im Niederdruck, vorzugsweise in einem Druckbereich zwischen 0,1 Pa und 10 Pa aufgebracht.

Die Erfindung führt auch auf ein Analysesystem, umfassend ein nach dem Konzept der Erfindung ausgebildetes Analysebehältnis sowie eine Analysevorrichtung zur chemischen und/oder biologischen und/oder physikalischen Analyse einer in dem Analysebehältnis aufnehmbaren oder bevorzugt bereits aufgenommenen Analysesubstanz. Im Hinblick auf mögliche, zur Anwendung kommende Analyseverfahren wird auf die Ansprüche verwiesen. Auf die dort genannten Analyseverfahren ist das Analysesystem sowie eine mögliche Verwendung des Analysebehältnisses nicht beschränkt.

Ganz besonders bevorzugt ist es, wenn die Barrierebeschichtung so beschaffen ist, dass aus einem mit der Barrierebeschichtung versehenen Behältnismaterials, insbesondere einem Kunststoff um mindestens 50% reduziert wird, verglichen mit einem identischen Analysebehältnis ohne eine ALD-Barriereschicht. Die Masse an Migrat wird dabei so gemessen, dass die Analysebehältnisse mit 95%igem Ethanol befüllt werden und das Ethanol bei 40 °C zehn Tage lang im Behältnis verbleibt. Die Migratlösung wird anschließend auf 0,2 ml eingeengt und mit einer Substanz als Messstandard bzw. Referenz versetzt. Die Masse an Migrat aus dem Kunststoff wird aus einem GC-FID Chromatogramm der Lösung gegen den zugegebenen Standard bestimmt.

Weitere Vorteile, Merkmale und Einzelheiten der Erfindung ergeben sich aus der nachfolgenden Beschreibung eines bevorzugten Ausführungsbeispiels sowie anhand der Figuren.

Diese zeigen in:
- Fig. 1:: eine mit einer ALD-Barrierebeschichtung versehene Pipettenspitze aus Kunststoff,
- Fig. 2:: ein Reaktionsgefäß aus Glas oder Kunststoff mit einer ALD-Barrierebeschichtung und
- Fig. 3: ein GC/FID-Chromatogramm zur Verdeutlichung der Barrierewirkung mit einer ALD-Barriereschicht versehenen Analysebehältnisses, hier einerPipette mit einem baugleichen Analysebehältnis ohne einer solchen ALD-Barrierebeschichtung, und
- Fig. 4: eine Tabelle als Legende zu dem Diagramm gemäß Fig. 3, aus welcher die zu den gezeigten Peaks zugehörigen Substanzen ersichtlich sind.

In den Figuren sind gleiche Elemente und Elemente mit der gleichen Funktion mit den gleichen Bezugszeichen gekennzeichnet.

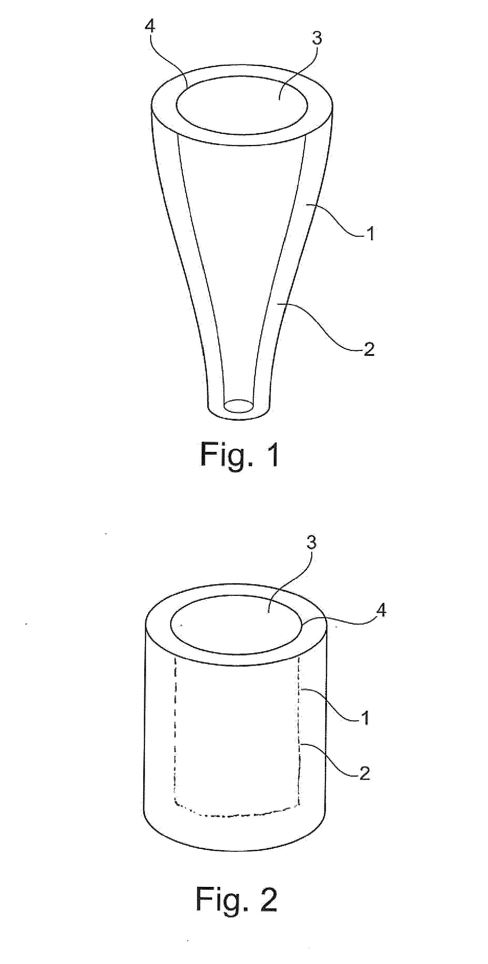

In Fig. 1 ist stark schematisiert ein als Pipettenspitze ausgebildetes Analysebehältnis 1 gezeigt. Dieses ist aus einem Behältnismaterial 2 hergestellt, im konkreten Ausführungsbeispiel handelt es sich bei dem Behältnismaterial 2 um einen Kunststoff. Die Pipettenspitze ist bevorzugt im Kunststoffspritzgussverfahren hergestellt.

Das Analysebehältnis 1 begrenzt in seinem Inneren eine dreidimensionale Kavität 3 zur zeitweisen Aufnahme einer Analysesubstanz. Um zu verhindern, dass Bestandteile bzw. Additive des Behältnismaterials 2 in die Analysesubstanz diffundieren, ist die Kavität 3 an ihrem Innenumfang, vorzugsweise vollumfänglich, mit einer viellagigen (> 50 Monolagen) ALD-Barrierebeschichtung 4 versehen, die im plasmaunterstützten ALD-Verfahren aufgebracht ist. Wie aus Fig. 1 zu erkennen ist, handelt es sich bei dem beispielhaft als Pipettenspitze gewählten Analysebehältnis 1 um ein Behältnis mit zwei axial beabstandeten Öffnungen. Die Pipettenspitze ist langgestreckt. Um eine Beschichtung der Kavität 3 an ihrem Innenumfang mit der ALD-Barrierebeschichtung 4 zu ermöglichen, wurde diese innerhalb der Reaktionskammer so angeordnet, dass das Analysebehältnis 1 in Richtung seiner Längserstreckung von den Präkusoren und anschließend von einem Spülgas durchströmt wurde.

In Fig. 2 ist ein alternatives, als Reaktionsgefäß ausgebildetes Analysebehältnis 1 gezeigt, welches eine Kavität 3 begrenzt, die an ihrem Innenumfang wiederum mit einer ALD-Barrierebeschichtung 4 versehen ist. Bei dem Behältnismaterial kann es sich beispielsweise um Glas oder einen Kunststoff handeln. Das Reaktionsgefäß weist eine einzige, in der Zeichnungsebene obere Öffnung auf. Das Aspektverhältnis, d.h. das Verhältnis aus der Kavitätentiefe und dem Kavitätendurchmesser, insbesondere im Bereich der Öffnung, ist größer als 2 : 1 - bevorzugt ist das Aspektverhältnis, wie im allgemeinen Beschreibungsteil angegeben, noch größer.

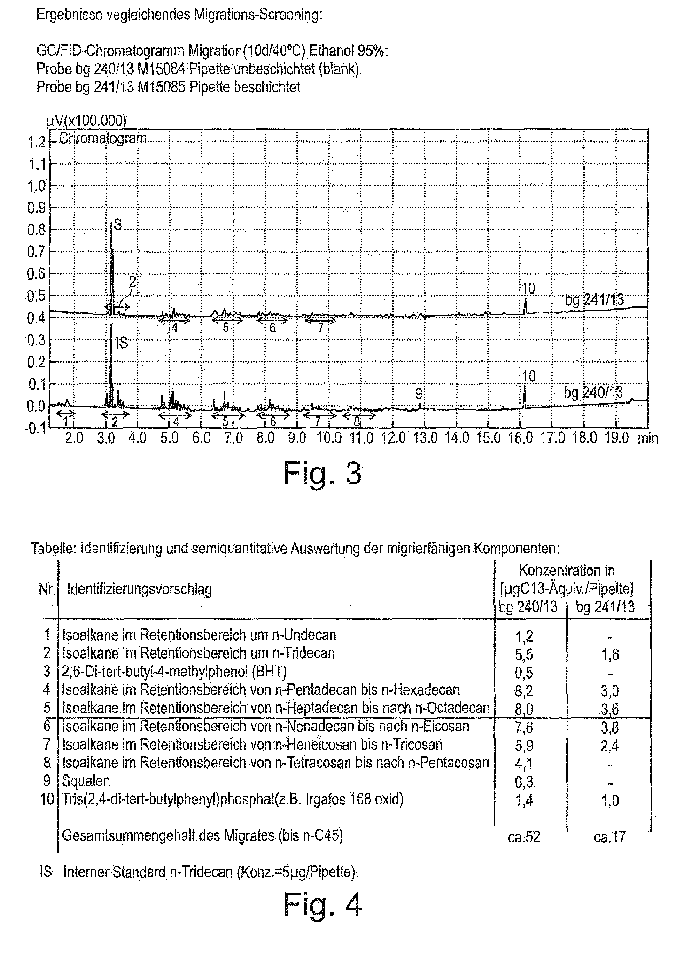

Aus einer Zusammenschau der Fig. 3 und 4, die exemplarisch die Wirkung einer ALD-Barriereschicht auf einer Pipette zeigen, ist ersichtlich, dass durch das Vorsehen der Barrierebeschichtung die Masse an Migrat um mehr als 50% hier beispielhaft 67% reduziert wurde. In dem Diagramm gemäß Fig. 3 ist das Analyseergebnis für eine unbeschichtete Pipette (Probe BG 240/13 M 15 084) sowie für eine mit einer ALD-Barrierebeschichtung versehene Pipette (Probe BG 241/13 M 15 085) dargestellt. Die Reduzierung des Migrats ist ausschließlich auf das Vorsehen der ALD-Barrierebeschichtung zurückzuführen, die in dem konkreten Ausführungsbeispiel mehr als 50 Atom- und/oder Moleküllagen mit jeweils identischer homogener Stöchiometrie umfasst.

### Bezugszeichen

- 1: Analysebehältnis
- 2: Behältnismaterial
- 3: Kavität
- 4: ALD-Barrierebeschichtung

## Patentansprüche

1. Analysebehältnis, aus einem Behältnismaterial (2), mit einer Kavität (3) zur zumindest zeitweisen Aufnahme einer, mit einem chemischen, physikalischen und/oder biologischen Verfahren zu analysierenden, bevorzugt fluiden, Analysesubstanz,
**dadurch gekennzeichnet,**
**dass** eine Oberfläche der Kavität (3) zur unmittelbaren Kontaktierung der Analysesubstanz von einer ALD-Barrierebeschichtung (4) zur Vermeidung oder Reduzierung einer Diffusion von Atomen und/oder Ionen und/oder Molekülen aus dem Behältnismaterial (2) in die Analysesubstanz gebildet ist.

2. Analysebehältnis nach Anspruch 1,
**dadurch gekennzeichnet,**
**dass** das Behältnismaterial (2) Kunststoff oder ein amorpher Feststoff, insbesondere Glas, ist.

3. Analysebehältnis nach einem der Ansprüche 1 oder 2,
**dadurch gekennzeichnet,**
**dass** das Analysebehältnis lediglich einseitig geöffnet ist und/oder ein Aspektverhältnis zwischen der Kavitätentiefe und der Öffnungsbreite einer Kavitätenöffnung größer als oder gleich 1 : 1, vorzugsweise größer als oder gleich 2 : 1, noch weiter bevorzugt größer als oder gleich 3 : 1, noch weiter bevorzugt größer als oder gleich 5 : 1, ganz besonders bevorzugt größer als oder gleich 7,5 : 1 ist, noch weiter bevorzugt größer als oder gleich 10 : 1 , besonders bevorzugt größer als oder gleich 15 : 1, ganz besonders bevorzugt größer als oder gleich 20 : 1.

4. Analysebehältnis nach einem der vorhergehenden Ansprüche,
**dadurch gekennzeichnet,**
**dass** die ALD-Barrierebeschichtung (4) über ihre Flächenerstreckung eine homogene Dicke aufweist.

5. Analysebehältnis nach einem der vorhergehenden Ansprüche,
**dadurch gekennzeichnet,**
**dass** die ALD-Barrierebeschichtung (4) unmittelbar auf dem, vorzugsweise zuvor aktivierten, Behältnismaterial (2) oder auf einer, insbesondere unmittelbar auf dem Behältnismaterial (2) vorgesehenen, bevorzugt durch ein PECVD oder PACVD Verfahren abgeschiedenen, Plasmapolymerbeschichtung, aufgebracht, und vorzugsweise dort kovalent gebunden, ist.

6. Analysebehältnis nach einem der vorhergehenden Ansprüchen,
**dadurch gekennzeichnet,**
**dass** die ALD-Barrierebeschichtung (4) mittels eines, insbesondere reinem, Kohlenwasserstoff-Präkusor und/oder eines fluorhaltigen Präkusors und/oder eines schwefelhaltigen Präkusors und/oder eines stickstoffhaltigen Präkusors hergestellt ist.

7. Analysebehältnis nach einem der vorhergehenden Ansprüche,
**dadurch gekennzeichnet,**
**dass** die ALD-Barrierebeschichtung (4) mindestens eine Barrierebeschichtungslage aus mehreren, vorzugsweise mindestens 50, Atom- und/oder Moleküllagen, bevorzugt Monolagen, weiter bevorzugt jeweils mit einer definierten Stöchiometrie, besteht.

8. Analysebehältnis nach einem der vorhergehenden Ansprüche,
**dadurch gekennzeichnet,**
**dass** zumindest eine Barrierebeschichtungslage aus Monolagen aus Aluminiumoxid (Al₂O₃), Siliziumdioxid (SiO₂) oder Titan(IV)oxid (TiO₂) besteht und/oder dass zumindest eine Barrierebeschichtungslage aus Monolagen aus einem Oxid, Nitrid, Sulfid, Borid oder einem Carbid eines Metalls oder eines Halbmetalls, besteht.

9. Analysebehältnis nach einem der vorhergehenden Ansprüche,
**dadurch gekennzeichnet,**
**dass** die ALD-Barrierebeschichtung (4) mittels eines plasmaunterstützten ALD-Verfahrens, bevorzugt bei einer Prozesstemperatur von weniger als 100°C, vorzugsweise bei Atmosphärendruck oder im Vakuum aufgebracht ist.

10. Analysebehältnis nach einem der vorhergehenden Ansprüche,
**dadurch gekennzeichnet,**
**dass** dieses als Pipettenspitze, Spritze, Reaktionsgefäß, Wellplatte, oder Laborgefäß ausgebildet ist.

11. Analysesystem, umfassend ein Analysebehältnis (1) nach einem der vorhergehenden Ansprüche sowie eine Analysevorrichtung zur Analyse einer in dem Analysebehältnis (1) aufnehmbaren und/oder aufgenommenen Analysesubstanz.

12. Verwendung eines Analysebehältnisses (1) nach einem der vorhergehenden Ansprüche zur zumindest zeitweisen Aufnahme einer, bevorzugt fluiden Analysesubstanz vor und/oder während einer chemischen, biologischen und/oder physkalischen Analyse, insbesondere nasschemische Analyseverfahren, photometrische Analyseverfahren, Titrationsanalyseverfahren, gravimetrische Analyseverfahren, spektroskopische Analyseverfahren, massenspektrometrische Analyseverfahren, kernresonanzspektroskopische Analyseverfahren, chromatographische Analyseverfahren, chemosensorische Analyseverfahren, bioelektrische Impedanzanalyseverfahren, simatische Analyseverfahren, genetische Analyseverfahren und dgl. der Analysesubstanz, bevorzugt in einem Analysesystem gemäß Anspruch 11.

13. Verfahren zum Herstellen eines Analysebehältnisses nach einem der Ansprüche 1 bis 10,
**dadurch gekennzeichnet,**
**dass** eine Oberfläche der Kavität (3) zur unmittelbaren Kontaktierung der Analysesubstanz mittels eines, insbesondere plasmaunterstützten, ALD-Beschichtungsverfahrens mit einer ALD-Barrierebeschichtung (4) beschichtet wird, um eine Diffusion von Atomen und/oder Ionen und/oder Molekülen aus dem Behältnismaterial in eine in der Kavität aufnehmbare Analysesubstanz zu vermeiden oder zu reduzieren.

14. Verfahren nach Anspruch 13,
**dadurch gekennzeichnet,**
**dass** die ALD-Barrierebeschichtung (4) durch Aufbringen mehrerer Monolagen, insbesondere Atom- und/oder Moleküllagen hergestellt wird.

15. Verfahren nach Anspruch 14,
**dadurch gekennzeichnet,**
**dass** eine der Monolagen vor dem Erzeugen der jeweils nächsten Monolage das Prozessgas in einer Beschichtungskammer getauscht und die zuvor aufgebrachte Monolage zum Aufbringen der nächsten Monolage aktiviert wird.
